# EUROPÄISCHE PATENTANMELDUNG

(11) **EP 2 886 367 A1**
(43) Veröffentlichungstag der Anmeldung: **24.06.2015**
(21) Anmeldenummer: 13198769.5
(22) Anmeldetag: 20.12.2013
(51) Int. Cl.: B44B 5/02, B22F 3/105, B29C 67/00, B41C 1/00, B44C 3/02, G03F 7/00

(54) **Verfahren zur Herstellung eines Druck- oder Prägeklischees**

(71) Anmelder: Mayr-Melnhof Karton AG, 1041 Wien (AT)
(72) Erfinder: Theis, Uwe, 54317 Riveris (DE); Höhnen, Roland, 54533 Bettenfeld (DE)
(74) Vertreter: Hofstetter, Schurack & Partner

(57) **Zusammenfassung**

Die vorliegende Erfindung betrifft ein Verfahren zur Herstellung eines Druck- oder Prägeklischees umfassend eine strukturiert ausgebildete Klischeeaußenfläche zur Erzeugung einer Druck- oder Prägestruktur auf einem Material oder einer Materialbahn, wobei zumindest die Klischeeaußenfläche mittels eines generativen Fertigungsverfahrens hergestellt wird.

## Beschreibung

Die vorliegende Erfindung betrifft ein Verfahren zur Herstellung eines Druck- oder Prägeklischees umfassend eine strukturiert ausgebildete Klischeeaußenfläche zur Erzeugung einer Druck- oder Prägestruktur auf einem Material oder einer Materialbahn.

Druck- oder Prägeklischees werden für eine Vielzahl von Druckverfahren benötigt und verwendet. Beispielhaft sind hier Hochdruckverfahren sowie der Flexo- und Tiefdruck zu nennen. Neben dem Bedrucken unterschiedlichster Materialien, wie zum Beispiel Papier, Karton oder Kunststofffolien, können diese Materialien auch geprägt werden. Über entsprechende Prägeklischees werden auf dem zu prägenden Material Oberflächenstrukturen unterschiedlichster Art aufgebracht. Derartige Prägestrukturen werden zum Beispiel auf Tapeten oder Zigarettenschachteln wie auch anderen Verpackungen aus Karton oder Kunststoff aufgebracht. Im Verpackungsbereich soll durch die zusätzliche Prägung der Verpackungsoberfläche eine Veredelung der entsprechenden Verpackung erreicht werden. Üblicherweise bestehen Druck- oder Prägeklischees aus Metall, wie zum Beispiel Zink, Kunststoff oder Photopolymeren.

Die Herstellung derartiger Druck- oder Prägeklischees ist aus dem Stand der Technik bekannt. So können Kunststoff- oder Metallplatten mit einer lichtempfindlichen Schicht versehen werden, wobei das zu druckende oder prägende Design mittels eines Negativfilms aufbelichtet wird. Die unbelichteten Partien werden anschließend chemisch weggeätzt oder abgewaschen, die belichteten Partien bleiben erhöht stehen. Bei dem Flexodruckverfahren werden Photopolymerdruckplatten verwendet, die entweder aus einem flüssigen Harz gegossen oder als unbelichtete Photodruckplatte geliefert werden. Dabei wird zunächst die Innenseite, das heißt die dem zu bedruckenden oder prägenden Material abgewandte Seite, mittels Belichtung ausgehärtet. Anschließend wird wiederum das zu druckende oder prägende Design mittels eines Negativfilms auf die Klischeeaußenfläche aufbelichtet und mittels UV-Belichtung ausgehärtet. Die nicht gehärteten Bereiche der Klischeeaußenfläche werden mit Lösungsmitteln ausgewaschen. Ein derart hergestelltes Druck- oder Prägeklischee wird schließlich mittels unterschiedlicher Methoden an einer Trägerplatte beziehungsweise einem Trägersleeve, einem Druck- oder Prägezylinder oder einer Druck- oder Prägehülse befestigt. Derartige Verfahren sind zeitaufwändig und teuer.

Es ist daher Aufgabe der vorliegenden Erfindung ein gattungsgemäßes Verfahren zur Herstellung eines Druck- oder Prägeklischees bereitzustellen, welches eine schnelle und ökonomische Fertigung von Druck- oder Prägeklischees ermöglicht. Eine weitere Aufgabe der Erfindung ist es, ein Druck- oder Prägeklischee bereitzustellen, welches schnell und ökonomisch hergestellt werden kann.

Die Aufgaben werden erfindungsgemäß durch ein Verfahren mit den Merkmalen des Patentanspruchs 1 sowie durch ein Druck- oder Prägeklischee mit den Merkmalen des Patentanspruch 15 gelöst. Vorteilhafte Ausgestaltungen mit zweckmäßigen Weiterbildungen der Erfindung sind in den Unteransprüchen angegeben.

Ein erfindungsgemäßes Verfahren zur Herstellung eines Druck- oder Prägeklischees umfassend eine strukturiert ausgebildete Klischeeaußenfläche zur Erzeugung einer Druck- oder Prägestruktur auf einem Material oder einer Materialbahn ist erfindungsgemäß dadurch gekennzeichnet, dass zumindest die Klischeeaußenfläche mittels eines generativen Fertigungsverfahrens hergestellt wird. Unter Klischeeaußenfläche wird dabei die dem zu bedruckenden oder zu prägenden Material zugewandte Oberfläche des Druck- oder Prägeklischees verstanden. Des Weiteren werden unter dem Begriff "Druck- oder Prägeklischee" auch Druck- oder Prägeplatten verstanden. Druck- oder Prägeklischees sowie Druck- oder Prägeplatten können starr oder flexibel ausgebildet sein. Durch die Verwendung eines generativen Fertigungsverfahrens ist eine schnelle und ökonomische Fertigung von Druck- oder Prägeklischees möglich. Insbesondere besteht die Möglichkeit, das Druck- oder Prägeklischees in ihrer Gesamtheit mittels des generativen Fertigungsverfahrens herzustellen. Dies bedeutet, dass es erfindungsgemäß möglich ist, nicht nur die das Druck- und/oder Prägebild bestimmende Klischeeaußenfläche mit entsprechenden Druck- und/oder Prägedaten zu versehen, sondern zum Beispiel auch eine Trägerplatte für das Druck- oder Prägeklischee generativ in einem einzigen Verfahrensschritt herzustellen. Die Klischeeaußenfläche kann daher vorteilhafterweise einstückig mit der Trägerplatte ausgebildet und generativ hergestellt werden. Es ist aber auch möglich, dass das Druck- oder Prägeklischee als separates Schichtelement generativ hergestellt wird und an der Trägerplatte angeordnet wird. Da die Anzahl an Fertigungsschritten minimiert werden kann, ist das erfindungsgemäße Verfahren besonders schnell und kostengünstig durchführbar. Zudem besteht die Möglichkeit, sehr schnell und flexibel auf mögliche Änderungen im Druck- und/oder Prägedesign reagieren zu können.

In vorteilhaften Ausgestaltungen des erfindungsgemäßen Verfahrens ist das generative Herstellungsverfahren ein Stereolithographieverfahren, ein Digital Light Processing-Verfahren, ein 3D-Druckverfahren, ein Schmelzschichtungsverfahren, ein Multi Jet Modeling-Verfahren, ein selektives Lasersinter- oder selektives Laserschmelzverfahren, ein Elektronenstrahlschmelzverfahren oder eine Kombination dieser Verfahren. Die Verwendung einzelner oder einer Kombination dieser Fertigungsverfahren richtet sich nach dem herzustellenden Produkt. So können zum Beispiel das Druck- oder Prägeklischee und eine entsprechende Trägerplatte aus unterschiedlichen Materialien und unterschiedlichen generativen Fertigungsverfahren hergestellt sein. In einer besonders vorteilhaften Ausgestaltung der Erfindung werden auch bei der Verwendung unterschiedlicher Materialien beziehungsweise unterschiedlicher generativer Fertigungsverfahren diese so ausgewählt, dass unterschiedliche Elemente des Druck- oder Prägeklischees in einem generativen Fertigungsschritt gefertigt werden können.

Wird als generatives Fertigungsverfahren ein Stereolithographieverfahren verwendet, so kann als Werkstoff insbesondere mindestens ein flüssiges, photosensitives Kunststoffmaterial und/oder ein Kunstharz und/oder ein photosensitiver Lack verwendet werden. Dabei kann das erfindungsgemäße Verfahren folgende Schritte umfassen: a) Bereitstellung von digitalisierten Daten, welche den dreidimensionalen Aufbau des Druck- oder Prägeklischees mit der strukturiert ausgebildeten Klischeeaußenfläche darstellen; b) schichtweises und lokales Aushärten des photosensitiven Kunststoffmaterials und/oder des photosensitiven Lacks zum Zuführen von Energie im Bereich einer Aufbau- und Aushärtzone; c) schichtweises Absenken des entstehenden Zwischenprodukts um eine vordefinierte Schichtdicke; und d) Wiederholen der vorhergehenden Schritte b) bis c) bis zur Fertigstellung des Druck- oder Prägeklischees mit der strukturiert ausgebildeten Klischeeaußenfläche. Dabei wird üblicherweise im Verfahrensschritt b) Laserenergie zugeführt. Des Weiteren besteht die Möglichkeit, dass nach dem Verfahrensschritt d) ein weiterer Aushärtungsprozess mittels UV-Strahlung durchgeführt wird.

In einer vorteilhaften Ausgestaltung des erfindungsgemäßen Verfahrens kann als Werkstoff für ein 3D-Druckverfahren mindestens ein UV-härtender Lack und/oder mindestens eine UV-härtende Tinte verwendet werden. Dieses alternative erfindungsgemäße Verfahren kann wiederum folgende Schritte umfassen: a) Bereitstellung von digitalisierten Daten, welche den dreidimensionalen Aufbau des Druck- oder Prägeklischees mit der strukturiert ausgebildeten Klischeeaußenfläche darstellen; b) schichtweises und lokales Aushärten des mindestens einen UV-härtenden Lacks und/oder der mindestens einen UV-härtenden Tinte durch Zuführen von UV-Licht im Bereich einer Aufbau- und Aushärtzone; und c) Wiederholen des vorhergehenden Schritts b) bis zur Fertigstellung des Druck- oder Prägeklischees mit der strukturiert ausgebildeten Klischeeaußenfläche. Die Verwendung eines derartigen 3D-Druckverfahrens bietet insbesondere für die Ausgestaltung der Klischeeaußenfläche, das heißt für das Aufbringen von insbesondere Bild- und/oder Prägeinformationen Vorteile.

In weiteren vorteilhaften Ausgestaltungen des erfindungsgemäßen Verfahrens wird als Werkstoff für das selektive Lasersinter- oder selektive Laserschmelzverfahren mindestens ein Kunststoff, Kunstharz, Metall, eine Metalllegierung oder Keramik oder eine Kombination dieser Werkstoffe in Pulverform verwendet. Hierbei können insbesondere Elemente der Druck- oder Prägeklischees, die zum Beispiel aus einem Kunststoff und/oder einem Metall wie Aluminium oder einer Aluminiumlegierung bestehen, generativ gefertigt werden. Bei der Verwendung des selektiven Lasersinter- oder selektiven Laserschmelzverfahrens können erfindungsgemäß folgende Schritte ausgeführt werden: a) Bereitstellung von digitalisierten Daten, welche den dreidimensionalen Aufbau des Druck- oder Prägeklischees mit der strukturiert ausgebildeten Klischeeaußenfläche darstellen; b) schichtweises Auftragen von mindestens einem pulverförmigen Bauteilwerkstoff auf eine Bauteilplattform im Bereich einer Aufbau- und Fügezone; c) schichtweises und lokales Verschmelzen und/oder Versintern des Bauteilwerkstoffs durch Zuführen von Energie im Bereich der Aufbau- und Fügezone; d) schichtweises Absenken der Bauteilplattform um eine vordefinierte Schichtdicke; und e) Wiederholen der Schritte b) bis d) bis zur Fertigstellung des Druck- oder Prägeklischees mit der strukturiert ausgebildeten Klischeeaußenfläche. Dabei wird üblicherweise im Verfahrensschritt c) Laserenergie zugeführt.

Die im Vorhergehenden beschriebenen generativen Fertigungsverfahren stellen nur beispielhaft die Möglichkeiten der erfindungsgemäßen generativen Fertigung von Druck- oder Prägeklischees oder von Teilen dieser Klischees dar. Weitere generative Fertigungsverfahren sind denkbar. Bei den generativ hergestellten Strukturen der Klischeeaußenfläche handelt es sich zum Beispiel um Druck- und/oder Prägeraster, die üblicherweise punktförmig aufgebaut sind. Des Weiteren besteht die Möglichkeit, dass zumindest einzelne Bereiche Oberfläche des Druck- oder Prägeklischees, insbesondere der Klischeeaußenfläche gehärtet werden. Dies kann zum Beispiel durch ein Verchromen dieser Bereiche erfolgen, so dass diese Bereiche vor Erosion, vorzeitiger Abnutzung oder Verunreinigungen geschützt sind. Des Weiteren besteht die Möglichkeit, dass die Oberfläche der Klischeeaußenfläche nach Fertigstellung zumindest teilweise auch mit anderen vorteilhaften Materialien beschichtet wird.

Die in den Klischeeaußenflächen erfindungsgemäß hergestellten Strukturen können als so genannte 2D- oder 3D-Strukturen ausgebildet sein. Im Bereich der Druck- und Prägetechnik werden dabei unter 2D-Strukturen derartige verstanden, die nur flächenmoduliert ausgeprägt sind. Unter eigentlichen 3D-Strukturen werden dagegen Strukturen verstanden, die tatsächlich deutlich volumenbeschreibende Strukturen entstehen lassen. Es kann auch von einstufigen, das heißt zweidimensionalen Prägungen, und mehrstufigen Prägungen, das heißt dreidimensionalen Prägungen, gesprochen werden.

Die Erfindung betrifft weiterhin ein Druck- oder Prägeklischee umfassend eine strukturiert ausgebildete Klischeeaußenfläche zur Erzeugung einer Druck- und/oder Prägestruktur auf einem Material oder einer Materialbahn hergestellt nach dem im Vorhergehenden beschriebenen erfindungsgemäßen Verfahren. Derartige Druck- oder Prägeklischees sind schnell und ökonomisch herstellbar. Die entsprechend bereitgestellten digitalisierten Daten, welche den dreidimensionalen Aufbau des Druck- oder Prägeklischees mit der strukturiert ausgebildeten Klischeeaußenfläche darstellen, können ohne Weiteres einer entsprechenden generativen Fertigungsvorrichtung zugeführt werden. Die generative Fertigungsvorrichtung fertigt dann nach den übermittelten Daten das entsprechende Druck- oder Prägeklischee. Da somit die Anzahl an Fertigungsschritten minimiert werden kann, ist das erfindungsgemäße Verfahren und die entsprechenden erfindungsgemäßen Druck- oder Prägeklischees besonders schnell und kostengünstig herstellbar. Dies gilt auch bei der Verwendung unterschiedlicher Materialien zur Herstellung der vorgenannten Produkte. Zudem besteht die Möglichkeit, sehr schnell und flexibel auf mögliche Änderungen im Druck- und/oder Prägedesign reagieren zu können.

## Patentansprüche

1. Verfahren zur Herstellung eines Druck- oder Prägeklischees umfassend eine strukturiert ausgebildete Klischeeaußenfläche zur Erzeugung einer Druck- oder Prägestruktur auf einem Material oder einer Materialbahn, **dadurch gekennzeichnet, dass** zumindest die Klischeeaußenfläche mittels eines generativen Fertigungsverfahrens hergestellt wird.

2. Verfahren nach Anspruch 1, **dadurch gekennzeichnet, dass** das Druck- oder Prägeklischee mindestens eine Trägerplatte umfasst und diese einstückig mit der strukturierten Klischeeaußenfläche ausgebildet und generativ mit dieser hergestellt wird.

3. Verfahren nach Anspruch 1, **dadurch gekennzeichnet, dass** das Druck- oder Prägeklischee mindestens eine Trägerplatte umfasst und die strukturierte Klischeeaußenfläche an der Trägerplatte angeordnet wird.

4. Verfahren nach einem der vorhergehenden Ansprüche, **dadurch gekennzeichnet, dass** das generative Herstellungsverfahren ein Stereolithographieverfahren, ein Digital Light Processing-Verfahren, ein 3D-Druckverfahren, ein Schmelzschichtungsverfahren, ein Multi Jet Modeling-Verfahren ein selektives Lasersinter- oder selektives Laserschmelzverfahren oder eine Kombination dieser Verfahren ist.

5. Verfahren nach Anspruch 4, **dadurch gekennzeichnet, dass** als Werkstoff für das Stereolithographieverfahren mindestens ein flüssiges, photosensitives Kunststoffmaterial und/oder ein Kunstharz und/oder ein photosensitiver Lack verwendet wird.

6. Verfahren nach Anspruch 5, **dadurch gekennzeichnet, dass** das Verfahren zur Herstellung des Druck- oder Prägeklischees folgende Schritte umfasst:
a) Bereitstellung von digitalisierten Daten welche den dreidimensionalen Aufbau des Druck- oder Prägeklischees mit der strukturiert ausgebildeten Klischeeaußenfläche darstellen;
b) Schichtweises und lokales Aushärten des photosensitiven Kunststoffmaterials und/oder des photosensitiven Lacks durch Zuführen von Energie im Bereich einer Aufbau- und Aushärtzone;
c) Schichtweises Absenken des entstehenden Zwischenprodukts um eine vordefinierte Schichtdicke; und
d) Wiederholen der vorhergehenden Schritte b) und c) bis zur Fertigstellung des Druck- oder Prägeklischees mit der strukturiert ausgebildeten Klischeeaußenfläche.

7. Verfahren nach Anspruch 6, **dadurch gekennzeichnet, dass** im Verfahrensschritt b) Laserenergie zugeführt wird.

8. Verfahren nach Anspruch 6 oder 7, **dadurch gekennzeichnet, dass** nach dem Verfahrensschritt d) ein weiterer Aushärtungsprozess mittels UV-Strahlung durchgeführt wird.

9. Verfahren nach Anspruch 4, **dadurch gekennzeichnet, dass** als Werkstoff für das 3D-Druckverfahren mindestens ein UV-härtender Lack und/oder mindestens eine UV-härtende Tinte verwendet wird.

10. Verfahren nach Anspruch 9, **dadurch gekennzeichnet, dass** das Verfahren zur Herstellung des Druck- oder Prägeklischees folgende Schritte umfasst:
a) Bereitstellung von digitalisierten Daten welche den dreidimensionalen Aufbau des Druck- oder Prägeklischees mit der strukturiert ausgebildeten Klischeeaußenfläche darstellen;
b) Schichtweises und lokales Aushärten des mindestens einen UV-härtenden Lacks und/oder der mindestens einen UV-härtenden Tinte durch Zuführen von UV-Licht im Bereich einer Aufbau- und Aushärtzone; und
c) Wiederholen des vorhergehenden Schritts b) bis zur Fertigstellung des Druck- oder Prägeklischees mit der strukturiert ausgebildeten Klischeeaußenfläche.

11. Verfahren nach Anspruch 4, **dadurch gekennzeichnet, dass** als Werkstoff für das selektive Lasersinter- oder selektive Laserschmelzverfahren mindestens ein Kunststoff, Kunstharz, Metall, Metalllegierung oder Keramik oder eine Kombination dieser Werkstoffe in Pulverform verwendet wird.

12. Verfahren nach Anspruch 11, **dadurch gekennzeichnet, dass** das Verfahren zur Herstellung des Druck- oder Prägeklischees folgende Schritte umfasst:
a) Bereitstellung von digitalisierten Daten welche den dreidimensionalen Aufbau des Druck- oder Prägeklischees mit der strukturiert ausgebildeten Klischeeaußenfläche darstellen;
b) Schichtweises Auftragen von mindestens einem pulverförmigen Bauteilwerkstoff auf eine Bauteilplattform im Bereich einer Aufbau- und Fügezone;
c) Schichtweises und lokales Verschmelzen und/oder Versintern des Bauteilwerkstoffs durch Zuführen von Energie im Bereich der Aufbau- und Fügezone;
c) Schichtweises Absenken der Bauteilplattform um eine vordefinierte Schichtdicke; und
d) Wiederholen der Schritte b) bis c) bis zur Fertigstellung des Druck- oder Prägeklischees mit der strukturiert ausgebildeten Klischeeaußenfläche.

13. Verfahren nach Anspruch 12, **dadurch gekennzeichnet, dass** im Verfahrensschritt c) Laserenergie zugeführt wird.

14. Verfahren nach einem der vorhergehenden Ansprüche, **dadurch gekennzeichnet, dass** die Oberfläche des Druck- oder Prägeklischees nach Fertigstellung zumindest teilweise beschichtet wird.

15. Druck- oder Prägeklischees mit einer strukturiert ausgebildeten Klischeeaußenfläche zur Erzeugung einer Druck- oder Prägestruktur auf einem Material oder einer Materialbahn hergestellt nach einem Verfahren gemäß einem der Ansprüche 1 bis 14.
